# EUROPÄISCHE PATENTSCHRIFT

(11) **EP 0 760 528 B1**
(45) Veröffentlichungstag und Bekanntmachung des Hinweises auf die Patenterteilung: **21.05.2003**
(21) Anmeldenummer: 96112954.1
(22) Anmeldetag: 12.08.1996
(51) Int. Cl.: H01L 29/06, H01L 29/861, H01L 29/872, H01L 29/78, H01L 29/167

(54) **Halbleiterbauelement auf Siliciumbasis mit hochsperrendem Randabschluss**
Semiconductor device on silicium base with a high blocking voltage edge termination
Dispositif semi-conducteur sur base de silicium avec bordure à blocage élevé

(30) Priorität: 25.08.1995 DE 19531369
(43) Veröffentlichungstag der Anmeldung: 05.03.1997
(73) Patentinhaber: Infineon Technologies AG, 81669 München (DE)
(72) Erfinder: Stephani, Dietrich, Dr., 91088 Bubenreuth (DE); Mitlehner, Heinz, Dr., 91080 Uttenreuth (DE)
(74) Vertreter: Patentanwälte Westphal, Mussgnug & Partner

(56) Entgegenhaltungen:
- WO-A-96/03774
- CH-A- 659 542
- DE-A- 3 225 991
- FR-A- 2 480 035
- FR-A- 2 497 405
- MCCOMBS A E JR ET AL: "Impact ionization of deep-impurities (In, Ni, Au) in silicon" , INTERNATIONAL JOURNAL OF ELECTRONICS, APRIL 1972, UK, VOL. 32, NR. 4, PAGE(S) 361 - 376 , ISSN 0020-7217 XP002056315 * Zusammenfassung; Abbildung 1 *

## Beschreibung

Die Erfindung betrifft ein Halbleiterbauelement.

Ein Halbleiterbauelement enthält im allgemeinen wenigstens einen aktiven Halbleiterbereich mit einem Halbleitergebiet eines Leitungstyps n oder p als Driftgebiet und zwei Elektroden zum Anlegen einer Betriebsspannung an das Driftgebiet sowie in der Regel weitere Halbleitergebiete zum Ausbilden bauelementspezifischer Halbleiterstrukturen. In einem leitenden Zustand des Bauelements trägt das Driftgebiet den elektrischen Strom von Ladungsträgern zwischen den beiden Elektroden. Im Sperrzustand des Bauelements nimmt das Driftgebiet dagegen eine Verarmungszone eines mit dem Driftgebiet gebildeten p-n-Übergangs oder sperrenden Metall-Halbleiter-Kontakts (Schottky-Kontakt) auf, die sich infolge der dann anliegenden, verglichen mit dem leitenden Zustand hohen Betriebsspannungen ausbildet. Die Verarmungszone wird oft auch als Raumladungszone oder Sperrschicht bezeichnet. Man unterscheidet zwischen unipolar aktiven und bipolar aktiven Halbleiterbereichen. Bei unipolar aktiven Halbleiterbereichen ist nur eine Sorte von Ladungsträgern, Elektronen oder Löcher, funktionsbestimmend, während bei bipolar aktiven Halbleiterbereichen beide Ladungsträgertypen, also Elektronen und Löcher, zur Funktion beitragen.

Im Sperrzustand entstehen an der Oberfläche des Bauelements vergleichsweise hohe elektrische Felder. Man muß deshalb dafür sorgen, daß diese elektrischen Felder an der Oberfläche stabil in das das Bauelement umgebende Medium mit einer maximalen Feldstärke übergehen, die deutlich unterhalb der Durchschlagsfeldstärke des umgebende Mediums liegt. Das umgebende Medium können dabei dielektrische Schichten zur Isolation und/oder Passivierung oder auch ein umgebendes Gas, in der Regel Luft, sein. Das Problem zu hoher Feldstärken an der Oberfläche eines Bauelements tritt besonders bei hohen Sperrspannungen wie bei Anwendungen in der Leistungselektronik, kleinen Abmessungen mit hohen Feldlinienkrümmungen oder hohen Dotierungen der Halbleitergebiete auf. Zur Verringerung der Feldstärken an der Oberfläche des Bauelements wird ein sogenannter Randabschluß eingesetzt, der in der Oberfläche des Bauelements erzeugt ist und den aktiven Bereich des Bauelements umgibt. Die Funktion eines Randabschlusses besteht neben der elektrischen Abschirmung des aktiven Halbleiterbereichs nach außen auch in einem Abbau der Feldlinienkrümmungen um den aktiven Halbleiterbereich, um Feldüberhöhungen im oberflächennahen Bereich innerhalb des Halbleiterbauelements zu verringern.

Aus dem Buch "Modern Power Devices" von B.J.Baliga, 1987, Verlag John Wiley and Sons (USA), Seiten 79 bis 129 sind verschiedene Ausführungsformen von Randabschlüssen für p-n-Übergänge (junction termination) in Halbleiterbauelementen auf Siliciumbasis für die Leistungselektronik bekannt. Solche p-n-Übergänge sind üblicherweise durch Diffusion eines Dotierstoffes in eine Oberfläche einer Siliciumschicht als Driftgebiet erzeugt, wobei das diffundierte Gebiet vom entgegengesetzten Leitungstyp ist wie die Siliciumschicht. An dem Rand des diffundierten Gebietes entsteht wegen der Feldlinienkrümmung in Abhängigkeit von der Tiefe dieses Gebietes eine Feldüberhöhung im Vergleich zum planaren p-n-Übergang.

Als Randabschluß können nun in einer ersten bekannten Ausführungsform sogenannte Feldringe (floating field rings) vorgesehen sein, die rings um das diffundierte Gebiet des p-n-Übergangs in der Siliciumschicht ebenfalls durch Diffusion erzeugt sind. Diese Feldringe sind vom gleichen Leitungstyp wie das diffundierte Gebiet des p-n-Übergangs und durch die entgegengesetzt dotierte Siliciumschicht vom diffundierten gebiet und jeweils voneinander getrennt. Es können einer oder mehrere Feldringe vorgesehen sein.

Eine zweite Möglichkeit, einen Randabschluß zu erhalten, besteht im Entfernen von Material und damit von Ladungen rings um den Rand des p-n-Übergangs durch mechanisches Abtragen oder Ätzen ("Beveled-edge termination" oder "Etch contour terminations"). Dadurch erhält man Mesastrukturen als Randabschlüsse.

Ein dritter bekannter Randabschluß für einen p-n-Übergang ist eine sogenannte Feldplatte (field plate). Dazu werden auf einen Randbereich um den p-n-Übergang eine Oxidschicht und darauf eine Metallschicht als Feldplatte aufgebracht. An die Metallschicht wird ein Feld angelegt , mit dem das Oberflachenpotential am Rand des p-n-Übergangs geändert wird. Dadurch kann ebenfalls die Verarmungszone des p-n-Übergangs und damit das Feld aufgeweitet werden. Die Feldplatte kann auch mit einer dem p-n-Übergang zum Anlegen einer Betriebsspannung zugeordneten Elektrodenschicht gebildet sein, die die Oxidschicht im Randbereich um den p-n-Übergang überlappt. Ein Randabschluß kann auch durch Kombination von Feldringen und Feldplatten gebildet sein ("Modern Power Devices", Seite 119).

Bei einer vierten bekannten Ausführungsform eines Randabschlusses werden kontrolliert entgegengesetzte Ladungen in die Oberfläche der als Driftgebiet vorgesehenen Siliciumschicht durch Ionenimplantation eingebracht.. Ein solcher Randabschluß wird als "junction termination extension" bezeichnet. Das implantierte Gebiet ist vom gleichen Leitungstyp wie das diffundierte Halbleitergebiet des p-n-Übergangs und damit entgegengesetzt dotiert zum Driftgebiet und weist eine niedrigere Dotierung auf als das diffundierte Gebiet. Außer mit einem in das Driftgebiet eindiffundierten Gebiet kann der p-n-Übergang in dieser vierten Ausführungsform auch mit einer auf der Oberfläche des Driftgebiets angeordneten und entgegengesetzt zum Driftgebiet dotierten Siliciumschicht gebildet sein. Die Ionenimplantation des Randabschlusses erfolgt dann am Rand der beiden den p-n-Übergang bildenden Siliciumschichten. Der p-n-Übergang wird durch diesen "junction termination extension"-Randabschluß praktisch erweitert, das elektrische Feld wird aufgeweitet und die Feldkrümmung verringert. Die Durchbruchsfestigkeit des Bauelements wird somit erhöht.

Ein mit dem "junction termination extension"-Randabschluß vergleichbarer, weiterer Randabschluß ist aus CH-A-659 542 bekannt und dort als Sperrschicht-Verlängerungsbereich bezeichnet. Dieser Randabschluß entspricht dem Oberbegriff der Ansprüche 1 und 9. Dieser Randabschluß ist für einen p-n-Übergang als bipolar aktivem Halbleiterbereich eines Halbleiterbauelements vorgesehen und kann durch Ionenimplantation oder epitaktisches Aufwachsen erzeugt werden. Die laterale Ausdehnung (W_{JER}) des Sperrschicht-Verlängerungsbereiches wird größer als etwa die Hälfte der Verarmungsbreite (W_{id}) der gering dotierten Seite des p-n-Übergangs eingestellt. Bei Werten für die laterale Ausdehnung (W_{JER}) von über dem Doppelten der Verarmungsbreite (W_{id}) ergeben sich bei diesem bekannten Randabschluß keine Verbesserungen mehr.

In "Modern Power Devices", Seite 128 wird der "junction termination extension"-Randabschluß für bipolare Transistoren (BJT), Feldeffekttransistoren (MOSFETs) und Thyristoren (SCR = Silicon Controlled Rectifier) vorgeschlagen. Wegen der mit diesem Randabschluß geschaffenen zusätzlichen parasitären Diode entstehen jedoch bipolare Leckströme im Sperrzustand des Bauelements und hohe Speicherladungen im Betrieb des Bauelements, die insbesondere bei einem unipolaren Silicium-MOSFET zu großen Problemen führen. Diese Leckströme und Speicherladungen nehmen noch deutlich zu, wenn man den Randabschluß vergrößert, weil die Ladungsträgerinjektion der parasitären Diode mit der Fläche des Randabschlusses zunimmt.

Der Erfindung liegt nun die Aufgabe zugrunde, ein Halbleiterbauelement auf Silciumbasis mit einem besonderen Randabschluß anzugeben. Bei einem unipolaren Bauelement soll insbesondere durch den Randabschluß die Speicherladung im Durchlaßbetrieb des Bauelements nicht wesentlich erhöht werden.

Diese Aufgabe wird gemäß der Erfindung gelöst mit den Merkmalen des Anspruchs 1 oder mit den Merkmalen des Anspruchs 9. Das Halbleiterbauelement enthält wenigstens ein Halbleitergebiet aus Silicium eines ersten Leitungstyps, das in einem aktiven Bereich des Bauelements bei Anlegen einer Sperrspannung an den aktiven Bereich eine Verarmungszone aufnimmt. Ein Randabschluß für den aktiven Bereich ist mit Silicium vom entgegengesetzten Leitungstyp wie das die Verarmungszone aufnehmende Halbleitergebiet gebildet und um den aktiven Bereich in oder an der Oberfläche dieses Halbleitergebietes angeordnet. Für diesen Randabschluß ist ein Dotierstoff (Dopand, Dotand) vorgesehen, der wenigstens ein tiefes Störstellen-Energieniveau von wenigstens etwa 0,1 eV (100 meV) aufweist. Bei einem p-leitenden Randabschluß gemäß Anspruch 1 ist der Dotierstoff ein Akzeptor und sein Energieniveau ist ein Akzeptorniveau, das bezogen auf das Valenzband des Siliciumkristalls angegeben wird. Bei einem n-leitenden Randabschluß gemäß Anspruch 9 ist der Dotierstoff ein Donator und sein Energieniveau ein Donatorniveau, das bezogen auf das Leitungsband des Siliciumkristalls angegeben wird.

Die Erfindung beruht auf der Überlegung, daß die Dotierstoffatome (Störstellenatome, atomare Gitterfehler) im Randabschluß aufgrund ihrer tiefen Energieniveaus bei den vergleichsweise niedrigen Durchlaßspannungen von typischerweise höchstens 5 V im Durchlaßbetrieb des Halbleiterbauelements im für Silicium zulässigen Betriebstemperaturbereich praktisch nicht ionisiert sind, bei den hohen Sperrspannungen von typischerweise 100 V bis 5000 V im Sperrzustand des Halbleiterbauelements dagegen zumindest weitgehend ionisiert sind. Im Durchlaßzustand des Halbleiterbauelements bleibt der Spannungsabfall über dem aktiven Bereich unter dem Spannungsabfall der parasitären p-n-Diode, die mit dem Randabschluß und dem entgegengesetzt dotierten Halbleitergebiet gebildet ist und der Randabschluß emittiert im wesentlichen keine Ladungsträger. Durch den Randabschluß werden somit praktisch keine zusätzlichen Speicherladungen erzeugt. Dies ist ein wesentlicher Vorteil gegenüber den aus dem Stand der Technik bekannten Randabschlüssen in Silicium, die mit Dotierstoffen mit relativ flachen Energieniveaus wie beispielsweise Bor (B) mit einem Akzeptorniveau von 0,045 eV, Phosphor (P) mit einem Donatorniveau von 0,045 eV oder Arsen (As) mit einem Donatorniveau von 0,054 eV dotiert werden. Im Sperrbetrieb des Halbleiterbauelements liegen dagegen aufgrund der vergleichsweise hohen Sperrspannungen wesentlich höhere elektrische Felder am Randabschluß an. Durch diese elektrischen Felder werden die tiefen Störstellen im Silicium des Randabschlusses zumindest weitgehend ionisiert und erzeugen eine feste Raumladung gemäß ihrer räumlichen Verteilung. Diese Raumladung bewirkt die elektrische Abschirmung des aktiven Bereichs des Halbleiterbauelements auch gegen äußere Felder und Ladungen.

Vorteilhafte Ausgestaltungen und Weiterbildungen des Halbleiterbauelements gemäß der Erfindung ergeben sich aus den vom Anspruch 1 und dem Anspruch 9 jeweils abhängigen Ansprüchen.

Als Akzeptoren für den Randabschluß sind demnach vorzugsweise Beryllium (Be) mit einem Akzeptorniveau von 0,17 eV, Zink (Zn) mit einem Akzeptorniveau von 0,26 eV, Nickel (Ni) mit einem Akzeptorniveau von 0,23 eV, Kobalt (Co) mit einem Akzeptorniveau von 0,35 eV, Magnesium (Mg) mit einem Akzeptorniveau von 0,17 eV, Zinn (Sn) mit einem Akzeptorniveau von 0,27 eV und/oder Indium (In) mit einem Akzeptorniveau von 0,16 eV vorgesehen. Als Donatoren werden vorzugsweise Schwefel (S) mit einem Donatorniveau von 0,26 eV, Selen (Se) mit einem Donatorniveau von 0,25 eV und/oder Titan (Ti) mit einem Donatorniveau von 0,21 eV verwendet.

Der Randabschluß kann in Form einer Feldringstruktur ausgebildet sein.

In einer besonders vorteilhaften Ausführungsform eines Halbleiterbauelements ist das Silicium-Halbleitergebiet zur Aufnahme der Verarmungszone des aktiven Bereichs in wenigstens einer lateralen Richtung bevorzugt ausgedehnt, beispielsweise als Silicium-Epitaxieschicht, und hängt die vertikale Ausdehnung der Verarmungszone von der am aktiven Bereich angelegten Sperrspannung ab. Der Randabschluß ist nun in der wenigstens einen lateralen Richtung stärker ausgedehnt als die Verarmungszone in vertikaler Richtung in ihrer maximalen vertikalen Ausdehnung (maximale Verarmungszonentiefe). Unter einer lateralen Richtung versteht man eine im wesentlichen parallel zu einer Oberfläche des Silicium-Halbleitergebiets verlaufende Richtung und unter der vertikalen Richtung die im wesentlichen senkrecht zur Oberfläche des Halbleitergebiets verlaufende Richtung. Es wird somit in das Halbleiterbauelement ein vergleichsweise großflächiger, zwischen Randabschluß und Halbleitergebiet gebildeter p-n-Übergang eingebaut. Wegen der Ausräumung von Ladungsträgern aus der Raumladungszone dieses eingebauten p-n-Übergangs wird das elektrische Feld im Bereich der Oberfläche des Driftgebietes aufgeweitet und zugleich der aktive Bereich des Halbleiterbauelements gegen äußere Ladungen und Felder nahezu vollständig abgeschirmt. Ein Avalanchedurchbruch erfolgt entfernt von der Oberfläche des Halbleitergebiets sicher im Volumen. Ein besonderer Vorteil der größeren lateralen Ausdehnung des Randabschlusses gegenüber der maximalen vertikalen Ausdehnung der Verarmungszone besteht darin, daß die Durchbruchsspannung des Halbleiterbauelements deutlich unempfindlicher gegenüber Schwankungen in der Dotierung oder allgemein der Ladungsträgerkonzentration in dem Randabschluß ist. Vorzugsweise grenzt der Randabschluß in dieser Ausführungsform unmittelbar an den aktiven Bereich an.

Durch Einstellen der lateralen Ausdehnung und/oder der vertikalen Ausdehnung und/oder des Dotierprofils des Randabschlusses kann die Ausdehnung der Verarmungszone des mit Randabschluß und Halbleitergebiet gebildeten p-n-Übergangs und damit die Aufweitung des elektrischen Feldes insbesondere an der Oberfläche des Halbleitergebiets weiter angepaßt werden, um die Durchbruchsfestigkeit und die Einstelltoleranz des Halbleiterbauelements noch weiter zu erhöhen.

Vorzugsweise wird die laterale Ausdehnung des Randabschlusses mindestens um den Faktor 3 größer eingestellt als die maximale vertikale Ausdehnung der vom Halbleitergebiet aufgenommenen Raumladungszone.

In einer besonderen Ausführungsform umfaßt der Randabschluß wenigstens zwei Halbleiterbereiche unterschiedlicher Dotierung. Dadurch kann eine weichere, d.h. glattere, Aufweitung des elektrischen Feldes erreicht werden. Das Halbleiterbauelement ist mit einem derartigen, mehrstufig dotierten Randabschluß besonders robust gegenüber Herstelltoleranzen. Die wenigstens zwei Halbleiterbereiche können in vertikaler Richtung übereinander oder lateral nebeneinander angeordnet sein.

In einer weiteren Ausführungsform kann ein dem aktiven Bereich des Halbleiterbauelements zugeordneter elektrischer Kontakt wenigstens teilweise auch den Randabschluß überlappen. Dadurch kann der Randabschluß auf ein definiertes Potential gelegt werden.

Der Randabschluß kann epitaktisch auf der Oberfläche des als Driftgebiet vorgesehenen Halbleitergebiets aufgewachsen sein oder auch durch Diffusion oder Ionenimplantation in das Halbleitergebiet erzeugt sein.

Das Halbleiterbauelement weist vorzugsweise wenigstens einen unipolar aktiven Bereich, beispielsweise einer MISFET-Struktur oder einer Schottky-Dioden-Struktur auf, kann aber mit wenigstens einem bipolar aktiven Bereich wie beispielsweise einer p-n-Dioden-, einer IGBT-, GTO- oder Thyristor-Struktur versehen sein.

Zur weiteren Erläuterung der Erfindung wird auf die Zeichnung Bezug genommen, in deren
- FIG 1: ein prinzipieller Aufbau eines Halbleiterbauelements mit einem Randabschluß
- FIG 2: ein Ausschnitt eines Halbleiterbauelements mit einem Randabschluß für eine Schottky-Dioden-Struktur in einem Querschnitt
- FIG 3: ein Ausschnitt eines Halbleiterbauelements mit einem Randabschluß für eine p-n-Dioden-Struktur in einem Querschnitt,
- FIG 4: ein Ausschnitt eines Halbleiterbauelements mit einem Randabschluß mit zwei unterschiedlich dotierten Halbleiterbereichen für eine MISFET-Struktur in einem Querschnitt,
- FIG 5: ein Ausschnitt eines Halbleiterbauelements mit einer Feldringstruktur als Randabschluß im Querschnitt
- FIG 6: ein Ausschnitt einer Feldverteilung bei einem Halbleiterbauelement mit einer Schottky-Dioden-Struktur in einem Querschnitt
- FIG 7: der Stromfluß in einem Halbleiterbauelement mit einer Schottky-Dioden-Struktur in einem Querschnitt
jeweils schematisch dargestellt sind. Einander entsprechende Teile sind mit denselben Bezugszeichen versehen.

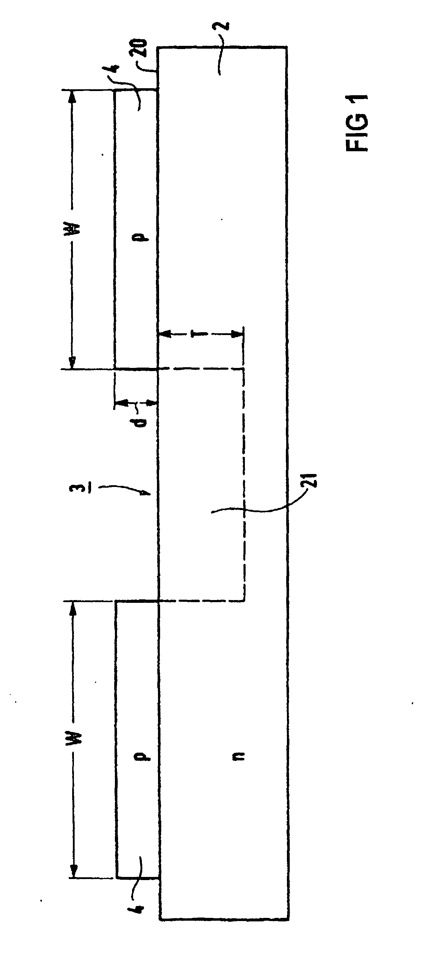

In FIG 1 sind ein Halbleitergebiet mit 2, ein elektronisch aktiver Bereich mit 3 und ein Randabschluß für diesen aktiven Bereich 3 mit 4, eine Oberfläche des Halbleitergebiets 2 mit 20 und eine in dem Halbleitergebiet 2 gebildete Verarmungszone (depletion zone) des aktiven Bereichs 3 mit 21 bezeichnet. Das Halbleitergebiet 2 bildet das Driftgebiet des Halbleiterbauelements und nimmt im sperrenden Zustand des Halbleiterbauelements die Verarmungszone 21 des aktiven Bereichs 3 auf. Diese Verarmungszone 21 kann die Raumladungszone eines in dem aktiven Bereich 3 mit dem Halbleitergebiet 2 gebildeten p-n-Übergangs zwischen zwei Halbleitern entgegengesetzten Leitungstyps oder auch die Sperrschicht eines Schottky-Kontakts zwischen einem Metall und einem Halbleiter sein. Das dargestellte Halbleiterbauelement ist vom vertikalen Bautyp, bei dem der Strom im Durchlaßbetrieb im wesentlichen in vertikaler Richtung, also im wesentlichen senkrecht zur Oberfläche 20, fließt. In der Leistungselektronik werden hauptsächlich solche vertikalen Halbleiterbauelemente eingesetzt. Prinzipiell ist der Randabschluß gemäß der Erfindung jedoch auch für laterale Halbleiterbauelemente mit lateralem, d.h. zur Oberfläche 20 im wesentlichen parallelen Stromfluß (Planartechnik) möglich.

Die vertikale Ausdehnung der Verarmungszone 21 ist abhängig von einer im aktiven Bereich 3 über entsprechende, nicht dargestellte Elektroden angelegten Sperrspannung. Die einer vorgegebenen Sperrspannung entsprechende maximale vertikale Ausdehnung der Verarmungszone 21 ist mit T bezeichnet. Das Halbleitergebiet 2 ist in wenigstens einer lateralen Richtung und vorzugsweise in allen lateralen Richtungen stärker ausgedehnt als in vertikaler Richtung. Vorzugsweise ist das Halbleitergebiet 2 eine auf einem nicht dargestellten Substrat angeordnete, beispielsweise epitaktisch aufgewachsene Siliciumschicht, die im allgemeinen niedriger dotiert als das Substrat.

Der Randabschluß 4 für den aktiven Bereich des Halbleiterbauelements ist an oder in der Oberfläche 20 des Halbleitergebiets 2 angeordnet. Der Randabschluß 4 umgibt lateral den gesamten aktiven Bereich. Ferner ist der Randabschluß 4 mit Silicum vom entgegengesetzten Leitungstyp wie das Halbleitergebiet 2 gebildet. In der dargestellten Ausführungsform ist das Halbleitergebiet 2 n-leitend, und der Randabschluß 4 ist p-leitend. Bei einem p-leitenden Halbleitergebiet 2 ist hingegen ein n-leitender Randabschluß 4 vorzusehen. Vorzugsweise ist der Randabschluß 4 durch Diffusion oder Ionenimplantation von Dotierstoffteilchen in die Oberfläche 20 des Silicium-Halbleitergebiets 2 oder durch Aufwachsen einer entsprechend zu dotierenden Epitaxieschicht aus Silicium auf die Oberfläche 20 des Halbleitergebiets 2 erzeugt.

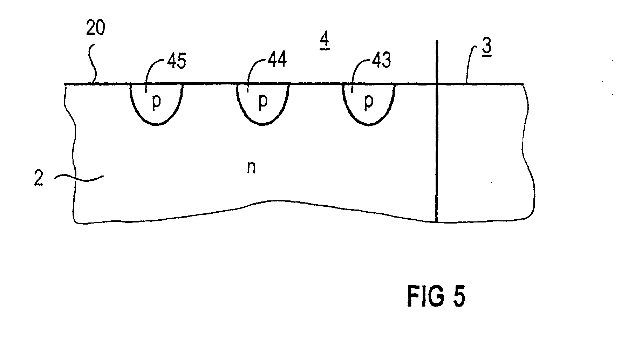

In der in FIG 1 dargestellten Ausführungsform berührt der Randabschluß 4 vorzugsweise den aktiven Bereich 3. Bei einer beispielsweise in FIG 5 dargestellten Ausführungsform mit wenigstens einem Feldring als Randabschluß ist der Randabschluß dagegen durch das Halbleitergebiet 2 vom aktiven Bereich 3 getrennt.

Die mit W bezeichnete laterale Ausdehnung des Randabschlusses 4 ist vorzugsweise größer als die maximale vertikale Ausdehnung T der Verarmungszone 21 im Halbleitergebiet 2. Vorzugsweise ist die laterale Ausdehnung W des Randabschlusses 4 wenigstens dreimal so groß wie die maximale vertikale Ausdehnung T der Verarmungszone 21. Bei einer Verarmungszonenausdehnung T von beispielsweise 10 µm ist die laterale Ausdehnung W des Randabschlusses 4 vorzugsweise zwischen 50 µm und 150 µm eingestellt. Die vertikale Ausdehnung d des Randabschlusses 4 ist vorzugsweise im wesentlichen konstant. Durch Einstellen der vertikalen Ausdehnung d des Randabschlusses 4 auf einen experimentell bestimmbaren Wert kann das Halbleiterbauelement insbesondere robuster gegenüber Herstellungstoleranzen bei der Dotierung des Randabschlusses 4 gemacht werden. Die vertikale Ausdehnung d des Randabschlusses 4 beträgt typischerweise zwischen 0,1 µm und 5 µm.

Mit einem solchen Randabschluß 4 wird in das Halbleiterbauelement im Bereich der Oberfläche 20 des Halbleitergebiets 2 ein vergleichsweise großflächiger p-n-Übergang eingebaut. Die im sperrenden Zustand des Halbleiterbauelements sich aufbauende Raumladungszone dieses p-n-Übergangs schirmt zum einen den aktiven Bereich und das Halbleitergebiet 2 gegen elektrische Felder und Ladungen von außerhalb des Bauelements ab und führt zum anderen zu einer Aufweitung des elektrischen Felds im Bereich der Oberfläche 20. Damit wird die Durchbruchsfestigkeit des Bauelements erhöht, und es können an den aktiven Bereich 3 höhere Sperrspannungen angelegt werden.

Für den Randabschluß 4 ist nun ein Dotierstoff (Dopand, Dotand) vorgesehen, der wenigstens ein tiefes Störstellen-Energieniveau von wenigstens etwa 0,1 eV (100 meV) aufweist. Die im Siliciumkristallgitter eingebauten Dotierstoffatome im Randabschluß 4 sind wegen ihrer tiefen Energieniveaus bei den vergleichsweise niedrigen Durchlaßspannungen von typischerweise höchstens 5 V im Durchlaßbetrieb des Halbleiterbauelements bei den für Silicium zulässigen Betriebstemperaturen praktisch nicht ionisiert. Im Durchlaßzustand des Halbleiterbauelements bleibt der Spannungsabfall über dem aktiven Bereich 3 deshalb unter dem Spannungsabfall der parasitären p-n-Diode, die mit dem Randabschluß 4 und dem entgegengesetzt dotierten Halbleitergebiet 2 gebildet ist und der Randabschluß 4 emittiert im wesentlichen keine Ladungsträger. Durch den Randabschluß 4 werden somit insbesondere bei einem unipolaren Halbleiterbauelement praktisch keine zusätzlichen Speicherladungen erzeugt.

Bei den hohen Sperrspannungen von typischerweise 100 V bis 5000 V im Sperrzustand des Halbleiterbauelements liegen dagegen hohe elektrische Felder am Randabschluß 4 an. Durch diese elektrischen Felder im Sperrbetrieb des Halbleiterbauelements werden die Dotierstoffatome im Randabschluß 4 trotz ihrer tiefen Störstellenniveaus zumindest weitgehend ionisiert und erzeugen eine feste Raumladung gemäß ihrer räumlichen Verteilung. Diese Raumladung bewirkt die elektrische Abschirmung des aktiven Bereichs 3 des Halbleiterbauelements durch den Randabschluß 4.

Für einen p-leitenden Randabschluß 4 werden Dotierstoffe gewählt, die in Silicium Akzeptoren sind. Bevorzugte Akzeptoren für den Randabschluß 4 sind Beryllium (Be) mit einem Akzeptorniveau von 0,17 eV, Zink (Zn) mit einem Akzeptorniveau von 0,26 eV, Nickel (Ni) mit einem Akzeptorniveau von 0,23 eV, Kobalt (Co) mit einem Akzeptorniveau von 0,35 eV, Magnesium (Mg) mit einem Akzeptorniveau von 0,17 eV, Zinn (Sn) mit einem Akzeptorniveau von 0,27 eV und/oder Indium (In) mit einem Akzeptorniveau von 0,16 eV.

Für einen n-leitenden Randabschluß 4 dotiert man das Silicium im Randabschluß 4 dagegen mit als Donatoren wirkenden Dotierstoffen. Als Donatoren werden vorzugsweise Schwefel (S) mit einem Donatorniveau von 0,26 eV, Selen (Se) mit einem Donatorniveau von 0,25 eV und/oder Titan (Ti) mit einem Donatorniveau von 0,21 eV verwendet.

Alle genannten Dotierstoffe können sowohl in einem Epitaxieprozeß, einem Diffusionsprozeß oder auch einem Ionenimplantationsprozeß in das Silicum eingebracht werden. Das Silicium des Randabschlusses 4 kann mit einem oder mehreren Dotierstoffen dotiert werden.

Die Dotierstoffkonzentrationen werden insbesondere in Abhängigkeit von der vertikalen Ausdehnung des Randabschlusses 4 gewählt und betragen im allgemeinen zwischen 10¹³ cm⁻³ und 10¹⁶ cm⁻³ und vorzugsweise zwischen 1·10¹⁵ cm⁻³ und 5·10¹⁵ cm⁻³.

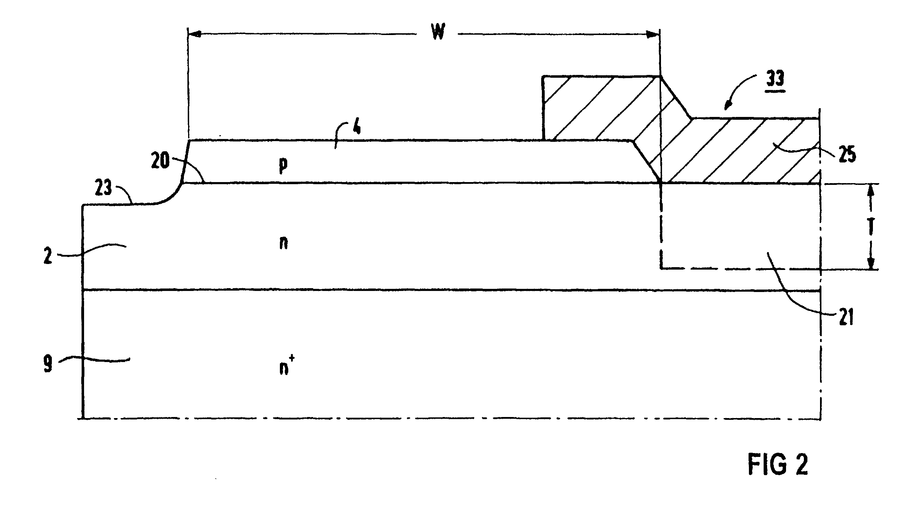

In FIG 2 ist ein Teil einer Ausführungsform eines Halbleiterbauelements mit wenigstens einer Schottky-Dioden-Struktur 33 als unipolar aktivem Bereich im Querschnitt dargestellt. Auf einem Substrat 9 aus einem n-dotierten Halbleiter, vorzugsweise Silicium, ist eine ebenfalls n-dotierte epitaktisch aufgewachsene Siliciumschicht als Halbleitergebiet 2 angeordnet. Die Schottky-Dioden-Struktur 33 enthält einen auf der Oberfläche 20 des Halbleitergebietes 2 angeordneten, im allgemeinen metallischen Kontakt 25 als Schottky-Kontakt. Die sich unterhalb des Kontakts 25 in dem Halbleitergebiet 2 bei Anlegen einer Sperrspannung ausbildende Sperrschicht der Schottky-Dioden-Struktur 33 bildet die Verarmungszone 21 im aktiven Bereich des Halbleiterbauelements. Unmittelbar anschließend an den Kontakt 25 ist auf dem Halbleitergebiet 2 eine epitaktisch aufgewachsene p-dotierte Halbleiterschicht als Randabschluß 4 angeordnet. Die den Randabschluß 4 bildende Halbleiterschicht ist in ihrer Schichtebene (laterale Ausdehnung W) deutlich stärker ausgedehnt als die Schichtdicke des Halbleitergebiets 2 und damit auch als die maximale vertikale Ausdehnung T der Verarmungszone 21. Der Randabschluß 4 kann sich bis zum Rand des Halbleitergebiets 2 erstrecken. Der Kontakt 25 ist vorzugsweise auch auf einem Teil des Randabschlusses 4 angeordnet (überlappender Kontakt). Außerdem können das Halbleitergebiet 2 und der Randabschluß 4 an ihren äußeren, vom aktiven Bereich abgewandten Rändern auch mit einer Aussparung 23 versehen sein, z.B. einem beveled-etch-Rand. Im Durchlaßbetrieb bleibt der Spannungsabfall zwischen dem Kontakt 25 und einer weiteren, nicht dargestellten Elektrode in der Schottky-Dioden-Struktur 33 unter dem Spannungsabfall der parasitären p-n-Diode zwischen Randabschluß 4 und Halbleitergebiet 2. Dadurch ist ein im wesentlichen speicherladungsfreier Betrieb des unipolaren Bauelements gewährleistet.

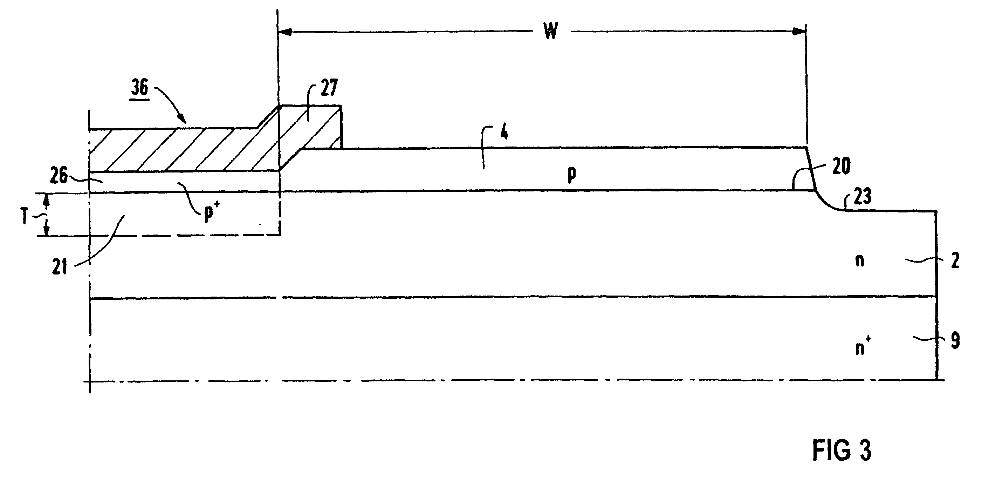

Ein Teil eines Halbleiterbauelements mit wenigstens einer p-n-Dioden-Struktur 36 als bipolar aktivem Bereich ist in FIG 3 im Querschnitt gezeigt. Das Halbleitergebiet 2 ist epitaktisch auf einem Halbleitersubstrat 9 aufgewachsen und vom gleichen Leitungstyp (n-leitend) wie das Substrat 9. Der p-n-Übergang der p-n-Dioden-Struktur 36 ist mit dem n-leitenden Halbleitergebiet 2 und einem auf der Oberfläche 20 des Halbleitergebiets 2 angeordneten, vorzugsweise epitaktisch aufgewachsenen p-leitenden Halbleitergebiet 26 gebildet. Auf diesem p-leitenden Halbleitergebiet 26 ist ein ohmscher Kontakt 27 angeordnet. Die Raumladungszone des p-n-Übergangs der p-n-Dioden-Struktur 36 bildet hier die Verarmungszone 21 des aktiven Bereichs. Als Randabschluß 4 für die p-n-Dioden-Struktur 36 ist eine vorzugsweise epitaktisch auf die Oberfläche 20 des Halbleitergebiets 2 aufgewachsene p-leitende Siliciumschicht vorgesehen. Diese Siliciumschicht des Randabschlusses 4 grenzt direkt an das p-leitende Halbleitergebiet 26 der p-n-Dioden-Struktur 36 an. Der ohmsche Kontakt 27 kann wieder den Randabschluß 4 teilweise überlappen. Außerdem kann auch wieder eine Aussparung 23 am Rand des Halbleitergebietes 2 vorgesehen sein. Anstelle epitaktisch aufgewachsener Halbleitergebiete können natürlich auch ionenimplantierte Halbleitergebiete vorgesehen sein. Alle Halbleitergebiete sind vorzugsweise mit Silicium gebildet.

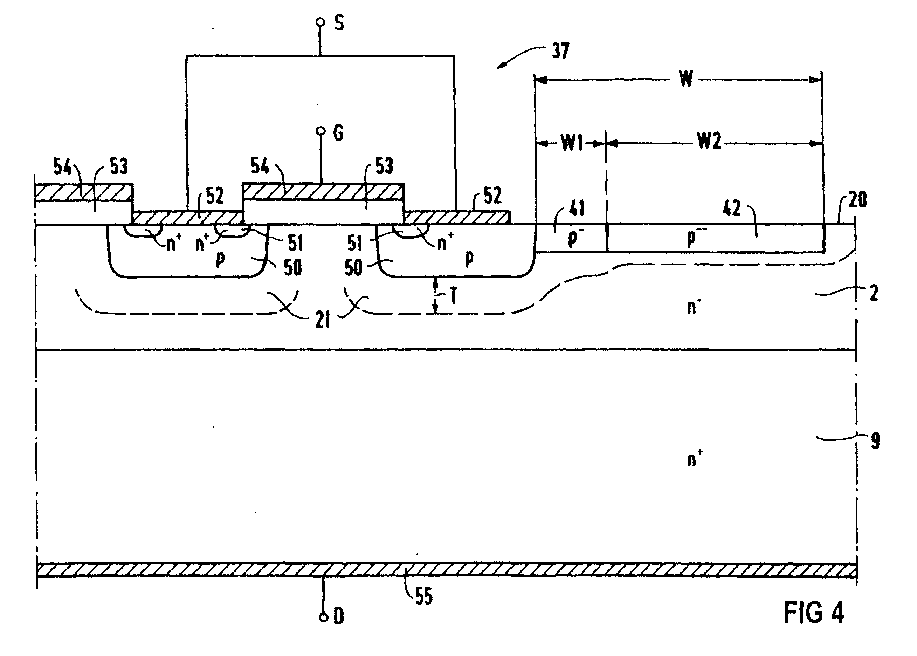

Die FIG 4 veranschaulicht ein Halbleiterbauelement mit wenigstens einer MISFET-Struktur 37 als weiteres Ausführungsbeispiel eines Halbleiterbauelements mit einem unipolar aktiven Bereich. Das auf dem n⁺-dotierten Substrat 9 angeordnete n-dotierte Halbleitergebiet 2 stellt das Driftgebiet der MISFET-Struktur 37 dar. Die MISFET-Struktur 37 umfaßt wenigstens ein p-dotiertes, in der Oberfläche 20 des Halbleitergebiets 2 durch Ionenimplantation oder Diffusion erzeugtes Basisgebiet 50, wenigstens ein innerhalb des Basisgebietes 50 ebenfalls durch Ionenimplantation oder Diffusion erzeugtes Sourcegebiet 51, wenigstens eine Sourceelektrode 52 der Source S, über die das Sourcegebiet 51 und das Basisgebiet 50 elektrisch kurzgeschlossen sind, eine über eine Isolatorschicht 53 elektrisch isoliert über einem das Sourcegebiet 51 und das Halbleitergebiet 2 verbindenden Kanalgebiet des Basisgebiets 50 angeordnete Gateelektrode 54 des Gate G (insulated gate) und eine auf der vom Halbleitergebiet 2 abgewandten Seite des Substrats 9 angeordnete Drainelektrode 55 der Drain D. Die vom Halbleitergebiet 2 aufgenommene Verarmungszone 21 des zwischen Basisgebiet 50 und Halbleitergebiet 2 gebildeten p-n-Übergangs ist schematisch angedeutet. Die MISFET-Struktur 37 kann insbesondere, wie in der FIG 4 dargestellt, aus einzelnen Zellen mit jeweils einem Basisgebiet 50 und wenigstens einem Sourcegebiet 51 mit zugeordneter Sourceelektrode 52 und die einzelnen Zellen überbrückenden isolierten Gateelektroden 54 aufgebaut sein. Solche Zellendesigns sind an sich in vielfältigen Ausführungen bekannt. Der Randabschluß 4 für die MISFET-Struktur 37 schließt unmittelbar an das am äußeren Rand der MISFET-Struktur 37 liegende Basisgebiet 50 an und ist ebenso wie das Basisgebiet 50 entgegengesetzt dotiert zum Halbleitergebiet 2. Vorzugsweise ist der Randabschluß 4 durch Ionenimplantation von Dotierstoffteilchen in die Oberfläche 20 des Halbleitergebietes erzeugt. Der Randabschluß 4 und/oder das Basisgebiet 50 der MISFET-Struktur 37 können aber auch Epitaxieschichten sein.

In der in FIG 4 dargestellten, vorteilhaften Ausführungsform ist der Randabschluß 4 aus wenigstens zwei unterschiedlich dotierten Halbleitergebieten 41 und 42 aufgebaut. Diese beiden Halbleitergebiete 41 und 42 sind lateral nebeneinander an der Oberfläche 20 des Halbleitergebiets 2 angeordnet und vorzugsweise entweder beide implantiert oder diffundiert oder beide epitaktisch aufgewachsen. Vorzugsweise weisen beide Halbleitergebiete 41 und 42 dabei etwa die gleiche vertikale Ausdehnung auf. Das der MISFET-Struktur 37 unmittelbar benachbarte Halbleitergebiet 41 ist niedriger dotiert (p⁻) als das angrenzende Basisgebiet 50 der MISFET-Struktur 37 und höher dotiert als das auf der von diesem Basisgebiet 50 abgewandten Seite lateral anschließende, p⁻⁻-dotierte Halbleitergebiet 42. Man erhält so einen Randabschluß 4 mit einer abgestuften Dotierung. In einer vorteihaften Ausführungsform ist die laterale Ausdehnung W1 des ersten Halbleitergebiets 41 kleiner als die laterale Ausdehnung W2 des zweiten Halbleitergebiets 42 eingestellt. Die gesamte laterale Ausdehnung W des Randabsch-lusses 4 ergibt sich dabei als Summe der einzelnen Ausdehnungen W1 und W2 der beiden Halbleitergebiete 41 und 42. Diese gesamte laterale Ausdehnung W des Randabschlusses 4 ist nun wieder größer eingestellt als die maximale vertikale Ausdehnung T der Verarmungszone 21 der MISFET-Struktur 37.

Die beiden Halbleitergebiete 41 und 42 können auch in einer nicht dargestellten Ausführungsform vertikal übereinander angeordnet sein. Ein solcher vertikaler Aufbau kann beispielsweise durch Ionenimplantation oder Diffusion mit unterschiedlichen Eindringtiefen erzeugt werden oder indem man die Halbleitergebiete nacheinander epitaktisch übereinander aufwächst. Das unten angeordnete Halbleitergebiet ist dann vorzugsweise niedriger dotiert als das oben angeordnete Halbleitergebiet. Die laterale Ausdehnung W des Randabschlusses ist dann im wesentlichen durch die größte laterale Ausdehnung der einzelnen, vertikal übereinander angeordneten Halbleitergebiete bestimmt. Vorzugsweise sind die lateralen Ausdehnungen aller Halbleitergebiete wenigstens annähernd gleich groß.

Ferner kann der Randabschluß auch aus einer lateralen oder einer vertikalen Anordnung von mehr als zwei, jeweils unterschiedlich dotierten Halbleitergebieten bestehen, wobei die Dotierung vorzugsweise lateral nach außen bzw. vertikal nach unten abnimmt.

Solche mehrstufigen Randabschlüsse sind nicht auf Halbleiterbauelemente mit MISFET-Strukturen beschränkt, sondern können auch bei allen anderen Halbleiterbauelementen vorgesehen sein. Diese mehrstufig dotierten Randabschlüsse haben den Vorteil, daß das elektrische Feld im Bereich der Oberfläche 20 des Halbleitergebietes 2 einen weicheren Verlauf von dem aktiven Bereich nach außen annimmt.

Es versteht sich, daß in allen bisher beschriebenen Ausführungsbeispielen die Leitungstypen aller Halbleitergebiete jeweils vertauscht werden können.

Die FIG 5 zeigt eine Ausführungsform eines Halbleiterbauelements mit einer Feldringstruktur als Randabschluß 4. Es sind drei Feldringe 43, 44 und 45 dargestellt, die zueinander beabstandet um den aktiven Bereich 3 des Halbleiterbauelements angeordnet sind. Der innerste Feldring 43 ist vom aktiven Bereich 3 durch das Halbleitergebiet 2 getrennt. Die einzelnen Feldringe 43, 44 und 45 sind voneinander durch das Halbleitergebiet 2 voneinander getrennt und vorzugsweise in die Oberfläche 20 des Silicium-Halbleitergebiet 2 eindiffundiert. Durch die Zahl der Feldringe der Feldringstruktur und die Abstände der Feldringe kann der Feldlinienverlauf im Bereich der Oberfläche 20 des Halbleitergebiets 2 eingestellt werden.

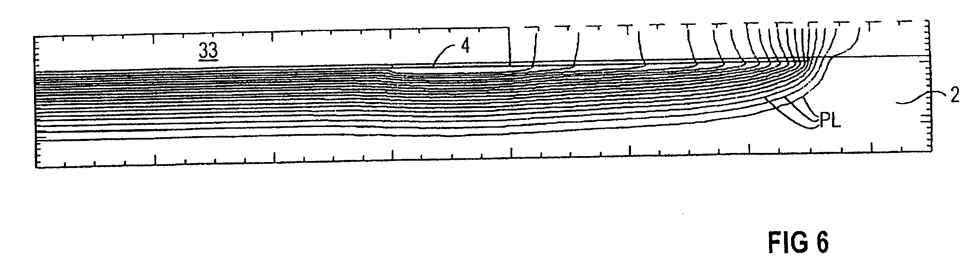

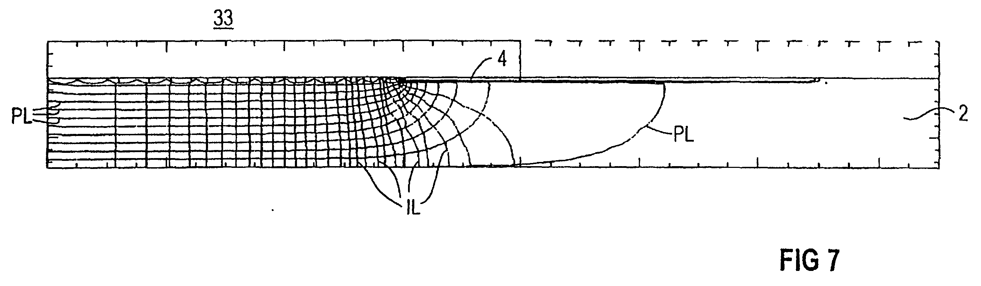

Die FIG 6 und 7 zeigen Ergebnisse von numerischen, rechnergestützten Simulationen von Halbleiterbauelementen mit Randabschlüssen gemäß der Erfindung. Die Rechnungen basieren auf Silicium als Halbleitermaterial für das Halbleiterbauelement. Als Dotierstoff für den Randabschluß 4 wurde Nickel (Ni) gewählt in einer Dotierstoffkonzentration von 5·10¹⁵ cm⁻³. Die Tiefe des Randabschlusses 4 beträgt 1 um und die laterale Ausdehnung das 5fache der vertikalen Ausdehnung des Halbleitergebiets 2.

FIG 6 zeigt eine mit dem Randabschluß 4 gemäß der Erfindung mögliche Potentialverteilung am Beispiel eines Halbleiterbauelements mit einer Schottky-Dioden-Struktur 33. Die elektrischen Äquipotentiallinien sind mit PL bezeichnet.

FIG 7 zeigt den Stromfluß in einem Halbleiterbauelement mit einer Schottky-Dioden-Struktur 33 und einem Randabschluß 4 gemäß der Erfindung bei einer Betriebstemperatur von 80°C. Die Stromflußlinien sind jeweils mit IL bezeichnet.

In allen Ausführungsformen können neben dem Randabschluß 4 noch zusätzliche Passivierungsschichten aus dielektrischen oder halbisolierenden Materialien vorgesehen sein. Die Passivierungsschichten können insbesondere aus amorphem SiC, amorphem Silicium (Si) oder amorphem Kohlenstoff (C) bestehen.

## Patentansprüche

1. Halbleiterbauelement mit
a) wenigstens einem Halbleitergebiet (2) aus n-leitendem Silicium, das in einem aktiven Bereich (3) bei Anlegen einer Sperrspannung an den aktiven Bereich (4) eine Verarmungszone (21) aufnimmt sowie
b) einem Randabschluß (4) für den aktiven Bereich (3), der
b1) um den aktiven Bereich (3) an oder in einer Oberfläche (20) des Halbleitergebiets (2) angeordnet ist und
b2) aus p-leitendem Silicium besteht, **dadurch gekennzeichnet, daß** das p-leitende silicium mit wenigstens einem Dotierstoff mit einem Akzeptorniveau von wenigstens etwa 0,1 eV in Silicium dotiert ist.

2. Halbleiterbauelement nach Anspruch 1, bei dem als Dotierstoff für den Randabschluß (4) Beryllium (Be) vorgesehen ist.

3. Halbleiterbauelement nach Anspruch 1, bei dem als Dotierstoff für den Randabschluß (4) Zink (Zn) vorgesehen ist.

4. Halbleiterbauelement nach Anspruch 1, bei dem als Dotierstoff für den Randabschluß (4) Nickel (Ni) vorgesehen ist.

5. Halbleiterbauelement nach Anspruch 1, bei dem als Dotierstoff für den Randabschluß (4) Kobalt (Co) vorgesehen ist.

6. Halbleiterbauelement nach Anspruch 1, bei dem als Dotierstoff für den Randabschluß (4) Magnesium (Mg) vorgesehen ist.

7. Halbleiterbauelement nach Anspruch 1, bei dem als Dotierstoff für den Randabschluß (4) Zinn (Sn) vorgesehen ist.

8. Halbleiterbauelement nach Anspruch 1, bei dem als Dotierstoff für den Randabschluß (4) Indium (In) vorgesehen ist.

9. Halbleiterbauelement mit
a) wenigstens einem Halbleitergebiet (2) aus p-leitendem Silicium, das in einem aktiven Bereich (3) bei Anlegen einer Sperrspannung an den aktiven Bereich (3) eine Verarmungszone (21) aufnimmt sowie
b) einem Randabschluß (4) für den aktiven Bereich (3), der
b1) um den aktiven Bereich (3) an oder in einer Oberfläche (20) des Halbleitergebiets (2) angeordnet ist und
b2) aus n-leitendem Silicium besteht, **dadurch gekennzeichnet, daß** das n-leitende silicinum mit wenigstens einem Dotierstoff mit einem Donatorniveau von wenigstens etwa 0,1 eV in Silicium dotiert ist.

10. Halbleiterbauelement nach Anspruch 9, bei dem als Dotierstoff für den Randabschluß (4) Schwefel (S) vorgesehen ist.

11. Halbleiterbauelement nach Anspruch 9, bei dem als Dotierstoff für den Randabschluß (4) Selen (Se) vorgesehen ist.

12. Halbleiterbauelement nach Anspruch 9, bei dem als Dotierstoff für den Randabschluß (4) Titan (Ti) vorgesehen ist.

13. Halbleiterbauelement nach einem der vorhergehenden Ansprüche, bei dem
a) das Halbleitergebiet (2) in wenigstens einer lateralen Richtung, die wenigstens annähernd parallel zur Oberfläche (20) des Halbleitergebiets (2) verläuft, stärker ausgedehnt ist als in einer vertikalen Richtung, die wenigstens annähernd senkrecht zur Oberfläche (20) des Halbleitergebiets (2) verläuft,
b) die vertikale Ausdehnung der Verarmungszone (21) von der an dem aktiven Bereich (3) angelegten Sperrspannung abhängt und
c) die laterale Ausdehnung (W) des Randabschlusses (4) größer ist als die maximale vertikale Ausdehnung (T) der vom Halbleitergebiet (2) aufgenommenen Verarmungszone (21).

14. Halbleiterbauelement nach Anspruch 13, bei dem die laterale Ausdehnung (W) des Randabschlusses (4) mindestens dreimal so groß wie die maximale vertikale Ausdehnung (T) der vom Halbleitergebiet (2) aufgenommenen Verarmungszone (21) ist.

15. Halbleiterbauelement nach Anspruch 13 oder Anspruch 14, bei dem der Randabschluß (4) wenigstens zwei Halbleiterbereiche (40 und 41) unterschiedlicher Dotierungskonzentrationen umfaßt.

16. Halbleiterbauelement nach Anspruch 15, bei dem die beiden Halbleiterbereiche (40, 41) lateral nebeneinander angeordnet sind.

17. Halbleiterbauelement nach Anspruch 15, bei dem die beiden Halbleiterbereiche in vertikaler Richtung übereinander angeordnet sind.

18. Halbleiterbauelement nach einem der Ansprüche 13 bis 17, bei dem ein dem aktiven Bereich (3) zugeordneter elektrischer Kontakt (25) wenigstens teilweise den Randabschluß (4) überlappt.

19. Halbleiterbauelement nach einem der Ansprüche 1 bis 12, bei dem der Randabschluß (4) als Feldringstruktur ausgebildet ist.

20. Halbleiterbauelement nach einem der vorhergehenden Ansprüche, bei dem der Randabschluß (4) epitaktisch auf der Oberfläche (20) des Halbleitergebiets (2) aufgewachsen ist.

21. Halbleiterbauelement nach einem der Ansprüche 1 bis 19, bei dem der Randabschluß (4) durch Ionenimplantation erzeugt ist.

22. Halbleiterbauelement nach einem der Ansprüche 1 bis 19, bei dem der Randabschluß (4) durch Diffusion erzeugt ist.

23. Halbleiterbauelement nach einem der vorhergehenden Ansprüche mit einem unipolar aktiven Bereich (32, 33).

24. Halbleiterbauelement nach einem der Ansprüche 1 bis 22 mit einem bipolar aktiven Bereich (36).

## Claims

1. A semiconductor device having
(a) at least one semiconductor zone (2) made from n-conducting silicon, which in an active zone (3) accommodates a depletion zone (21) when a blocking voltage is applied to the active zone (4)
and also
b) a border (4) for the active zone (3), which
b) is disposed around the active zone (3) or in a surface (20) of the semiconductor zone (2) and
b2) is made from p-conducting silicon,
**characterised in that** the p-conducting silicon is doped with at least one dopant having an acceptor level of at least roughly 0.1 eV in silicon.

2. A semiconductor device according to Claim 1, in which beryllium (Be) is provided as the dopant for the border (4).

3. A semiconductor device according to Claim 1, in which zinc (Zn) is provided as the dopant for the border (4).

4. A semiconductor device according to Claim 1, in which nickel (Ni) is provided as the dopant for the border (4).

5. A semiconductor device according to Claim 1, in which cobalt (Co) is provided as the dopant for the border (4).

6. A semiconductor device according to Claim 1, in which magnesium (Mg) is provided as the dopant for the border (4).

7. A semiconductor device according to Claim 1, in which tin (Sn) is provided as the dopant for the border (4).

8. A semiconductor device according to Claim 1, in which indium (In) is provided as the dopant for the border (4).

9. A semiconductor device having
a) at least one semiconductor zone (2) made from p-conducting silicon, which in an active zone (3) accommodates a depletion zone (21) when a blocking voltage is applied to the active zone (3),
and also
b) a border (4) for the active zone (3), which
b1) is disposed around the active zone (3) at or in a surface (20) of the semiconductor zone (2) and
b2) is made from n-conducting silicon,
**characterised in that** the n-conducting silicon is doped with at least one dopant having a donor level of at least 0.1 eV in silicon.

10. A semiconductor device according to Claim 9, in which sulphur (S) is provided as the dopant for the border (4).

11. A semiconductor device according to Claim 9, in which selenium (Se) is provided as the dopant for the border (4).

12. A semiconductor device according to Claim 9, in which titanium (Ti) is provided as the dopant for the border (4).

13. A semiconductor device according to one of the preceding Claims, in which
a) the semiconductor zone (2) has greater dimensions in at least one lateral direction running at least roughly parallel to the surface (20) of the semiconductor zone (2) than in a vertical direction running at least roughly perpendicular to the surface (20) of the semiconductor zone (2),
b) the vertical dimension of the depletion zone (21) depends on the blocking voltage applied to the active zone (3) and
c) the lateral dimension (W) of the border (4) is greater than the maximum vertical dimension (T) of the depletion zone (21) accommodated by the semiconductor zone (2).

14. A semiconductor device according to Claim 13, in which the lateral dimension (W) of the border (4) is at least three times as large as the maximum vertical dimension (T) of the depletion zone (21) accommodated by the semiconductor zone (2).

15. A semiconductor device according to Claim 13 or Claim 14, in which the border (4) comprises at least two semiconductor zones (40 and 41) having different dopant concentrations.

16. A semiconductor device according to Claim 15, in which the two semiconductor zones (40, 41) are disposed laterally next to one another.

17. A semiconductor device according to Claim 15, in which the two semiconductor zones are disposed one above the other in the vertical direction.

18. A semiconductor device according to one of Claims 13 to 17, in which an electrical contact (25) associated with the active zone (3) overlaps the border (4) at least partially.

19. A semiconductor device according to one of Claims 1 to 12, in which the border (4) is constructed as a field ring structure.

20. A semiconductor device according to one of the preceding Claims, in which the border (4) is epitaxially grown on the surface (20) of the semiconductor zone (2).

21. A semiconductor device according to one of Claims 1 to 19, in which the border (4) is produced by ion implantation.

22. A semiconductor device according to one of Claims 1 to 19, in which the border (4) is produced by diffusion.

23. A semiconductor device according to one of the preceding Claims, having a unipolar active zone (32, 33).

24. A semiconductor device according to one of Claims 1 to 22, having a bipolar active zone (36).

## Revendications

1. Dispositif semi-conducteur comprenant
a) au moins un domaine semi-conducteur (2) en silicium à conductivité de type n qui reçoit une zone d'appauvrissement (21) dans un domaine actif (3) lorsqu'on applique une tension de blocage au domaine actif (3),
b) une bordure (4)pour la zone active (3) qui
b1) est prévue autour du domaine actif (3) sur ou dans la surface supérieure (20) du domaine semi-conducteur (2) et
b2) ce domaine actif est en silicium à conductivité de type (p),
**caractérisé en ce que**
le silicium à conductivité de type (p) est dopé avec au moins une matière de dopage ayant un niveau d'accepteur d'au moins environ 0,1 eV dans le silicium.

2. Dispositif semi-conducteur selon la revendication 1,
dans lequel
la matière dopante pour la bordure (4) est du béryllium (Be).

3. Dispositif semi-conducteur selon la revendication 1,
dans lequel
la matière dopante pour la bordure est du zinc (Zn).

4. Dispositif semi-conducteur selon la revendication 1,
dans lequel
la matière dopante pour la bordure est du nickel (Ni).

5. Dispositif semi-conducteur selon la revendication 1,
dans lequel
la matière dopante pour la bordure est du cobalt (Co).

6. Dispositif semi-conducteur selon la revendication 1,
dans lequel
la matière dopante pour la bordure est du magnésium (Mg).

7. Dispositif semi-conducteur selon la revendication 1,
dans lequel
la matière dopante pour la bordure est de l'étain (Sn).

8. Dispositif semi-conducteur selon la revendication 1,
dans lequel
la matière dopante pour la bordure est de l'indium (In).

9. Dispositif semi-conducteur comportant
a) au moins un domaine semi-conducteur (2) en silicium à conductivité p qui reçoit une zone d'appauvrissement (21) dans un domaine actif (3) lorsqu'on applique une tension de blocage au domaine actif (3) et
b) une bordure (4) pour le domaine actif (3) qui
b1) est prévue autour du domaine actif (3) dans ou sur la surface supérieure (20) du domaine semi-conducteur (2) et
b2) formé de silicium à conductivité de type (n),
**caractérisé en ce que**
le silicium à conductivité de type n est dopé avec au moins une matière dopante ayant un niveau de donneur d'au moins environ 0,1 eV dans le silicium.

10. Dispositif semi-conducteur selon la revendication 9,
dans lequel
la matière dopante de la bordure (4) est du souffre (S)

11. Dispositif semi-conducteur selon la revendication 9,
dans lequel
la matière dopante de la bordure (4) est du sélénium (Se)

12. Dispositif semi-conducteur selon la revendication 9,
dans lequel
la matière dopante de la bordure (4) est du titane (Ti)

13. Dispositif semi-conducteur selon l'une des revendications précédentes,
dans lequel
a) le domaine semi-conducteur (2) est dirigé au moins dans une direction latérale au moins sensiblement parallèle à la surface supérieure (20) du domaine semi-conducteur (2) avec une plus forte extension que dans la direction verticale et celle-ci étant au moins sensiblement perpendiculaire à la surface supérieure (20) du domaine semi-conducteur (2),
b) l'extension verticale de la zone d'appauvrissement (21) dépend de la tension de blocage appliquée au domaine actif (3) et
c) l'extension latérale (W) de la bordure (4) est supérieure à l'extension verticale maximale (T) de la zone d'appauvrissement (21) reçue par le domaine semi-conducteur (2).

14. Dispositif semi-conducteur selon la revendication 13,
dans lequel
l'extension latérale (W) de la bordure (4) est au moins trois fois aussi grande que l'extension verticale maximale (T) de la zone d'appauvrissement (21) dans le domaine semi-conducteur (2).

15. Dispositif semi-conducteur selon la revendication 13 ou 14,
dans lequel
la bordure (4) comprend au moins deux domaines semi-conducteurs (40, 41) à concentration de dopage différente.

16. Dispositif semi-conducteur selon la revendication 15,
dans lequel
les deux domaines semi-conducteurs (40, 41) sont juxtaposés latéralement.

17. Dispositif semi-conducteur selon la revendication 15,
dans lequel
les deux domaines semi-conducteurs sont superposés dans la direction verticale.

18. Dispositif semi-conducteur selon l'une des revendications 13 à 17,
dans lequel
un contact électrique (25) associé au domaine actif (3) chevauche au moins en partie la bordure (4).

19. Dispositif semi-conducteur selon l'une des revendications 1 à 12,
dans lequel
la bordure (4) est réalisée sous la forme d'une structure en anneau de champ.

20. Dispositif semi-conducteur selon l'une des revendications précédentes,
dans lequel
la bordure (4) est développée par croissance épitaxiale sur la surface supérieure (20) du domaine semi-conducteur (2).

21. Dispositif semi-conducteur selon l'une des revendications 1 à 19,
dans lequel
la bordure (4) est obtenue par implantation ionique.

22. Dispositif semi-conducteur selon l'une des revendications 1 à 19,
dans lequel
la bordure (4) est obtenue par diffusion.

23. Le dispositif semi-conducteur selon l'une des revendications précédentes comportant un domaine actif unipolaire (32, 33).

24. Dispositif semi-conducteur selon l'une des revendications 1 à 22, avec un domaine actif bipolaire (36).
